# EUROPEAN PATENT SPECIFICATION

(11) **EP 2 151 812 B1**
(45) Date of publication and mention of the grant of the patent: **09.04.2014**
(21) Application number: 09167335.0
(22) Date of filing: 06.08.2009
(51) Int. Cl.: G09G 3/20, G09G 3/32

(54) **Driver IC and organic light emitting display device using the same**
Treiber-IC und damit versehene organische lichtemittierende Anzeigevorrichtung
Circuit intégré de commande et affichage électroluminescent organique l'utilisant

(30) Priority: 06.08.2008 KR 20080076941
(43) Date of publication of application: 10.02.2010
(73) Proprietor: Samsung Display Co., Ltd., Yongin-City, Gyeonggi-Do, 446-711 (KR)
(72) Inventor: PARK, Sung-Cheon, Chungcheongnam-do (KR); LEE, Wook, Chungcheongnam-do (KR)
(74) Representative: Gulde Hengelhaupt Ziebig & Schneider

(56) References cited:
- EP-A2- 2 023 326
- US-A1- 2002 175 662
- US-A1- 2005 190 128

## Description

### BACKGROUND OF THE INVENTION

### 1. Field of the Invention

The present invention relates to a driver circuit and an organic light emitting display device using the same.

### 2. Description of Related Art

Recently, various flat panel display devices having reduced weight and volume compared to cathode ray tubes have been developed. Among the different types of flat panel display devices are liquid crystal display devices, field emission display devices, plasma display panels, and organic light emitting display devices, among others.

Among the flat panel display devices, the organic light emitting display device has various advantages, such as excellent color reproducibility and reduced thickness. Accordingly, the organic light emitting display device has expanded its market into a variety of applications, such as PDAs, MP3 players, and portable phones.

The organic light emitting display device displays an image using organic light emitting diodes (OLEDs) which generate light by recombining electrons and holes generated corresponding to a flow of current.

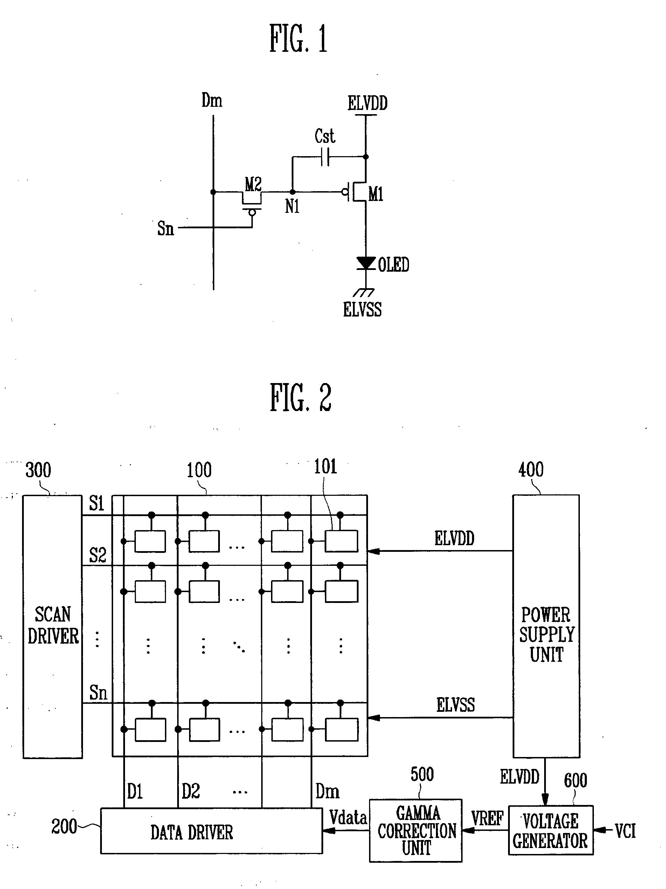

FIG. 1 is a circuit diagram showing a pixel of a general organic light emitting display device. Referring to FIG. 1, a pixel includes a first transistor M1, a second transistor M2, a capacitor Cst, and an organic light emitting diode (OLED).

A source electrode of the first transistor M1 is coupled to a first power supply ELVDD, a drain electrode thereof is coupled to an anode electrode of the OLED, and a gate electrode thereof is coupled to a first node N1.

A source electrode of the second transistor M2 is coupled to a data line Dm, a drain electrode thereof is coupled to the first node N1, and a gate electrode thereof is coupled to a scan line Sn.

A first electrode of the capacitor Cst is coupled to the first power supply ELVDD and a second electrode thereof is coupled to the first node N1.

An anode electrode of the OLED is coupled to the drain electrode of the first transistor M1 and a cathode electrode thereof is coupled to a second power supply ELVSS.

The pixel determines an amount of current flowing to the OLED in accordance with a voltage difference between the source electrode and the gate electrode of the first transistor M1. In other words, the amount of current flowing to the OLED is determined according to the voltage of the first power supply ELVDD and data signals from the data line Dm.

As a result, if a ripple occurs in the voltage of the first power supply ELVDD, a voltage difference between the source electrode and the gate electrode of the first transistor M1 is varied, and the current flowing to the OLED is fluctuated. Accordingly, flicker or noise is observed.

U.S. patent application 2002/0175662 A1 deals with a circuit for generating a power supply voltage for a liquid crystal panel which comprises a power supply unit adapted to generate a first power supply voltage and a second power supply voltage and a reference potential generating circuit adapted to generate a plurality of reference potentials derived from the first power supply voltage.

### SUMMARY OF THE INVENTION

Accordingly, exemplary embodiments of the present invention provide a driver IC and an organic light emitting display device using the same for preventing or reducing occurrences of flicker or noise according to claim 1.

### BRIEF DESCRIPTION OF THE DRAWINGS

The accompanying drawings illustrate exemplary embodiments of the present invention, and, together with the following description, serve to explain the principles of the present invention.

FIG. 1 is a circuit diagram showing a pixel of an organic light emitting display device according to an embodiment of the present invention;

FIG. 2 is a schematic block diagram showing a structure of an organic light emitting display device according to an embodiment of the present invention;

FIG. 3 is a schematic circuit diagram showing a gamma correction unit of the organic light emitting display device shown in FIG. 2;

FIG. 4 is a circuit diagram showing a structure of a voltage generator utilized for generating voltage shown in FIG. 3; and

FIG. 5 is a conceptual view of the organic light emitting display device according to an embodiment of the present invention.

### DETAILED DESCRIPTION OF EXEMPLARY EMBODIMENTS

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some elements that are not essential to a complete understanding of the invention are omitted for clarity. Also, like reference numerals refer to like elements throughout.

FIG. 2 is a schematic block diagram showing a structure of an organic light emitting display device according to an exemplary embodiment of the present invention. Referring to FIG. 2, an organic light emitting display device includes a display unit 100, a data driver 200, a scan driver 300, a power supply unit 400, a gamma correction unit 500, and a voltage generator 600.

The display unit 100 includes a plurality of pixels 101, each pixel 101 including an organic light emitting diode (not shown) for emitting light corresponding to a flow of current. The display unit 100 includes n scan lines S1, S2,...,Sn-1, and Sn which transfer scan signals in a row direction and m data lines D1, D2, ...Dm-1, and Dm which transfer data signals in a column direction. By way of example, pixels of the organic light emitting display device may have a structure similar to the structure as illustrated in and described with respect to FIG. 1, but may not be limited thereto.

Also, the display unit 100 is driven by receiving first power ELVDD and second power ELVSS having a voltage level lower than the first power ELVDD. Therefore, the display unit 100 is light-emitted by a flow of current to the OLED in accordance with the scan signal, the data signal, the first power ELVDD, and the second power ELVSS, to thereby display the image.

The data driver 200, generates data signals using image signals having red, blue, and green components. The data driver 200 is coupled to the data lines D1, D2, ...Dm-1, and Dm of the display unit 100 to apply the generated data signals to the display unit 100.

The scan driver 300 generates scan signals, and is coupled to the scan lines S1, S2,... Sn-1, and Sn to transfer the scan signals to specific rows of the display unit 100. The pixel 101 to which a scan signal is transferred receives a voltage corresponding to the data signal output from the data driver 200 to transfer the voltage corresponding the data signal to the pixel 101.

The power supply unit 400 boosts the power input from the outside to generate the first power ELVDD and inverts the input power to generate the second power ELVSS.

The gamma correction unit 500 divides a reference voltage VREF to generate gray levels. Thereby, the gamma correction unit 500 generates a voltage Vdata of a data signal corresponding to each gray level.

The voltage generator 600 generates the reference voltage VREF using the first power ELVDD or a power VCI input from the outside. The generated reference voltage VREF is transferred to the gamma correction unit 500. The voltage generator 600 generates the reference voltage VREF using the input power VCI initially, and generates the reference voltage VREF using the first power ELVDD after a time (e.g., a predetermined time) has elapsed.

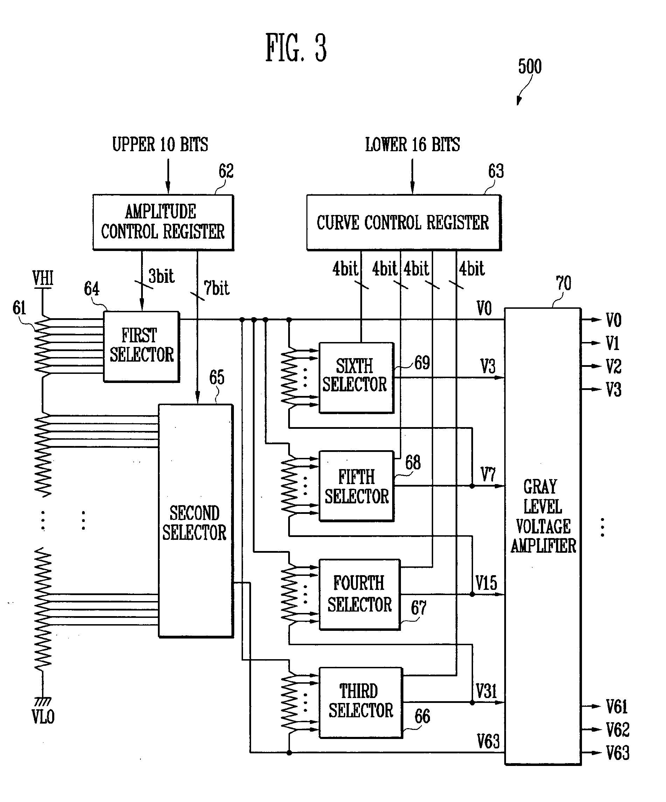

FIG. 3 is a schematic circuit diagram showing the gamma correction unit of the organic light emitting display device shown in FIG. 2. Referring to FIG. 3, the gamma correction unit 500 includes a ladder resistor 61, an amplitude control register 62, a curve control register 63, first to sixth selectors 64 to 69, and a gray level voltage amplifier 70.

The ladder resistor 61 defines a reference voltage supplied from the voltage generator 600 as a highest level voltage VHI and includes a plurality of variable resistors between a lowest level voltage VLO and the highest level voltage VHI, the resistors being coupled serially. A plurality of gray level voltages (e.g., gamma voltages) are generated by utilizing the ladder resistor 61.

The amplitude control register 62 outputs a 3-bit register setting value to the first selector 64 and outputs a 7-bit register setting value to the second selector 65. At this time, the selectable number of gray levels may be increased as the number of bits is increased, and the register setting value may be changed so that the gray level voltages can be selected differently.

The curve control register 63 outputs a 4-bit register setting value to each of the third to sixth selectors 66 to 69. At this time, the register setting value may be changed and the selectable gray level voltage may be controlled according to the register setting value.

The amplitude control register 62 is input with the upper 10 bits of a register signal and the curve control register 63 is input with the lower 16 bits of the register signal.

The first selector 64 selects a gray level voltage corresponding to the a 3-bit register setting value from the amplitude control register 62 from among a plurality of gray levels, and outputs a selected gray level voltage as the highest gray level voltage.

The second selector 65 selects a gray level voltage corresponding to the 7-bit register setting value from the amplitude control register 62 from among the plurality of gray levels divided through the ladder resistor 61, and outputs a selected gray level voltage as the lowest gray level voltage.

The third selector 66 divides a voltage range between the level scale voltage output from the first selector 64 and the gray level voltage output from the second selector 65 into a plurality gray level voltages through a plurality of resistor rows, and selects a gray level voltage corresponding to the 4-bit register setting value and outputs the selected gray level voltage.

The fourth selector 67 divides a voltage range between the gray level voltage output from the first selector 64 and the gray level voltage output from the third selector 66 through a plurality of resistor rows and selects a gray level voltage corresponding to the 4-bit register setting value, and outputs the selected gray level voltage.

The fifth selector 68 selects a gray level voltage corresponding to the 4-bit register setting value from among the gray level voltages between the first selector 64 and the fourth selector 67, and outputs the selected gray level voltage.

The sixth selector 69 selects a gray level voltage corresponding to the 4-bit register setting value from among the gray level voltages between the first selector 64 and the fifth selector 68, and outputs the selected gray level voltage.

Curve control of intermediate gray levels may be performed according to the register setting value of the curve control register 63 by the above-mentioned operation, making it possible to control gamma characteristics for each light emitting device. The resistance value of each ladder resistor 61 may be set so that a potential difference between the respective gray levels is set to be larger as a smaller gray level is displayed in order to make the gamma curve project upwardly, or alternatively may be set so that a potential difference between the respective gray levels is smaller as a smaller gray level is displayed in order to make the gamma curve project downwardly.

The gray level amplifier 70 outputs the plurality of gray level voltages corresponding to each of the plurality of gray levels to be displayed on the display unit 100. FIG. 3 outputs gray level voltages corresponding to 64 gray levels.

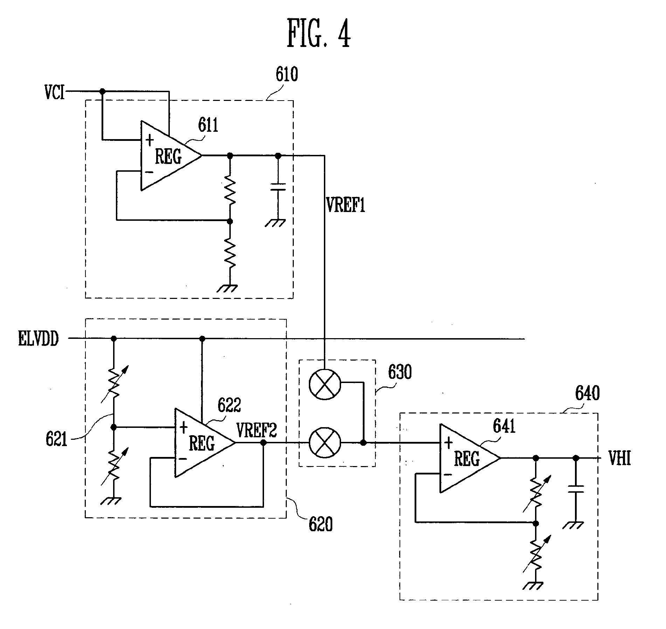

FIG. 4 is a circuit diagram showing a structure of a voltage generator utilized for generating voltage shown in FIG. 2. Referring to FIG. 4, the voltage generator 600 includes a first reference voltage generator 610, a second reference voltage generator 620, a selector 630, and an output buffer 640.

The first reference voltage generator 610 receives an input voltage VCI from the outside to generate and output a first reference voltage VREF1 using a regulator 611.

The second reference voltage generator 620 receives a first power ELVDD from the power supply unit 400 and outputs a second reference voltage VREF2 using the regulator 622. Here, the first power ELVDD has a designated voltage level based on the resistor row 621.

If the gamma correction unit 500 uses the first reference voltage VREF1, ripples that occur in the first power ELVDD have no effect on the first reference voltage VREF1, since the first reference voltage VREF1 has a constant voltage. Therefore, if the voltage transferred to the gate electrode of the first transistor M1 of the pixel shown in FIG. 1 is constant, but the voltage of the first power ELVDD transferred to the source electrode of the first transistor M1 is fluctuated, such that the amount of current flowing to the OLED is different due to the fluctuation in the voltage difference between the source electrode and the gate electrode, noise or flicker may occur.

However, if a ripple which occurs in the voltage of the first power supply ELVDD is also transferred to the second reference voltage generator 620, the second reference voltage VREF2 is generated such that the ripple also occurs in the second reference voltage VREF2 corresponding to the ripple of the first power ELVDD. Therefore, both the voltage transferred to the source electrode and the voltage transferred to the gate electrode of the first transistor M1 of the pixel shown in FIG. 1 fluctuate concurrently, such that the voltage difference between the source electrode and the gate electrode may be maintained. Thereby, the amount of current flowing to the OLED is substantially maintained, and noise and/or flicker are reduced.

The output buffer 640 includes the regulator 641, which receives one of the first reference voltage VREF1 and the second reference voltage VREF2, and transfers it to the gamma correction unit 500.

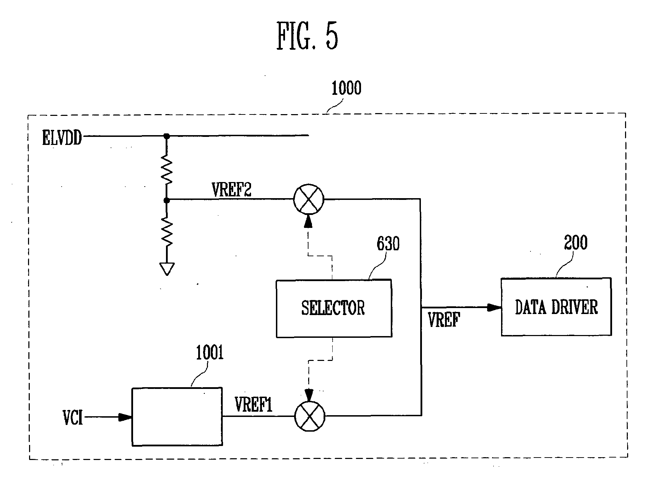

FIG. 5 is a conceptual view of a process of generating the gray scale voltage in the driver circuit of the organic light emitting display device according to an exemplary embodiment of the present invention. Referring to FIG. 5, the driver circuit generates the first reference voltage VREF1 using the external power supply VCI transferred from the outside and generates the second reference voltage VREF2 using the first power ELVDD generated from the power supply unit 400. The driver circuit selects one of the first reference voltage VREF1 and the second reference voltage VREF2. In one embodiment, the selection of voltage is performed by the selector 630 using software. The data driver 200 generates a data signal by utilizing the selected voltage. The first reference voltage VREF1 may be formed by utilizing a circuit block 1001 and the second reference voltage VREF2 may be formed by voltage-dividing the first power ELVDD.

Since the power supply unit 400 is not in an enable state in the initial stage, the selector 630 initially enables the data driver 200 to generate a data signal using the first reference voltage VREF1. If the power supply unit 400 is in an enable state, since the first power ELVDD is being generated, the selector 630 enables the data driver 200 to generate a data signal using the second reference voltage VREF2 corresponding to the first power ELVDD.

If the data signal is generated in the data driver 200 using the second reference voltage VREF2, when a ripple occurs in the first voltage ELVDD, a ripple corresponding to the ripple of the first power ELVDD occurs in the voltage of the data signal. In other words, when the voltage of the first power ELVDD is high, the voltage of the data signal is correspondingly high, and when the voltage of the first power ELVDD is low, the voltage of the data signal is correspondingly low. As shown in FIG. 1, the data signal is transferred to the gate electrode of the first transistor M1 and the first power ELVDD is transferred to the source electrode thereof. In other words, when the voltage of the source electrode of the first transistor M1 is high, the voltage of the gate electrode is correspondingly high, and when the voltage of the source electrode of the first transistor M1 is low, the voltage of the gate electrode is correspondingly low. Therefore, the voltage difference between the source and gate electrodes of the first transistor M1 may be constantly maintained. For this reason, the current generated in the pixel may also be constantly maintained, making it possible to reduce the noise or flicker.

## Claims

1. A driver circuit comprising:
a gamma correction unit (500) adapted to generate a plurality of gray level voltages in accordance with a selected one of a plurality of predetermined gamma curves and a reference voltage;
a data driver (200) adapted to generate data signals by selecting one of the plurality of gray level voltages in accordance with an image signal; and
a power supply unit (400) adapted to generate a first power supply voltage (ELVDD) and a second power supply voltage (ELVSS); a voltage generator (600) adapted to generate the reference voltage (VREF) in that the reference voltage (VREF) may be either a first reference voltage (VREF1) derived from an input power supply voltage supplied from the outside (VCI) or a second reference voltage (VREF2) derived from the first power supply voltage (ELVDD), wherein the voltage generator (600) comprises:
a first reference voltage generator (610) adapted to generate the first reference voltage from the input power supply voltage;
a second reference voltage generator (620) adapted to generate the second reference voltage from the first power supply voltage (ELVDD); and
a selector (630) adapted to select one of the first reference voltage or the second reference voltage and to provide the selected one of the first reference voltage or the second reference voltage to the gamma correction unit (500) and
**characterized in that**
the selector (630) is configured to select the first reference voltage for an initial driving period during which the rower supply unit (400) is not in an enable state, and to select the second reference voltage after the initial driving period during which the rower supply unit (400) is in an enable state.

2. An organic light emitting display device comprising:
a display unit (100) adapted to display an image corresponding to data signals, scan signals, a first power supply voltage, and a second power supply voltage; and
a scan driver (300) for generating the scan signals and for transmitting the generated scan signals to the display unit (100),
**characterized by** a driver circuit according to claim 1.

3. The organic light emitting display device as claimed in claim 2, wherein the display unit (100) comprises a plurality of pixels (101), each of the plurality of pixels (101) comprising an organic light emitting diode (OLED) for emitting light in accordance with the first power supply voltage (ELVDD) and the data signals.

4. The organic light emitting display device of claim 3, wherein each of the plurality of pixels (101) further comprise at least one thin film transistor (M1) having a source electrode coupled to the first power supply voltage(ELVDD), a gate electrode adapted to receive the data signals from the data driver, and a drain electrode coupled to the organic light emitting diode (OLED).

5. The organic light emitting display device as claimed in one of the claims 2 through 4, wherein the gamma correction unit (500) is configured to generate gray level voltages for 64 gray levels.

## Patentansprüche

1. Treiberschaltung, aufweisend:
eine Gammakorrektureinheit (500), die angepasst ist, um eine Vielzahl von Graustufenspannungen gemäß einer ausgewählten aus einer Vielzahl vorbestimmter Gammakurven und einer Referenzspannung zu erzeugen;
einen Datentreiber (200), der angepasst ist, um Datensignale durch Selektieren einer aus der Vielzahl der Graustufenspannungen gemäß einem Bildsignal zu erzeugen; und
eine Energieversorgungseinheit (400), die angepasst ist, um eine erste Versorgungsspannung (ELVDD) und eine zweite Versorgungsspannung (ELVSS) zu erzeugen;
einen Spannungsgenerator (600), der angepasst ist, die Referenzspannung (VREF) zu erzeugen, so dass die Referenzspannung (VREF) entweder eine erste Referenzspannung (VREF1), die von einer von außen (VCI) zugeführten Eingangsversorgungsspannung abgeleitet ist, oder eine zweite Referenzspannung (VREF2), die von der ersten Versorgungspannung (ELVDD) abgeleitet ist, sein kann, wobei der Spannungsgenerator (600) aufweist:
einen ersten Referenzspannungsgenerator (610), der angepasst ist, um die erste Referenzspannung aus der Eingangsversorgungsspannung zu erzeugen;
einen zweiten Referenzspannungsgenerator (620), der angepasst ist, um die zweite Referenzspannung aus der ersten Versorgungsspannung (ELVDD) zu erzeugen; und
einen Selektor (630), der angepasst ist, um eine der ersten Referenzspannung oder der zweiten Referenzspannung zu selektieren und die Gammakorrektureinheit (500) mit der selektierten der ersten Referenzspannung oder der zweiten Referenzspannung zu versorgen; und
**dadurch gekennzeichnet, dass**
der Selektor (630) konfiguriert ist, um die erste Referenzspannung für eine Anfangsansteuerperiode, während der die Versorgungsspannungseinheit (400) nicht in einem Freigabezustand ist, zu selektieren und um die zweite Referenzspannung nach der Anfangsansteuerperiode, während der die Versorgungsspannungseinheit (400) in einem Freigabezustand ist, zu selektieren.

2. Organische lichtemittierende Anzeigevorrichtung, aufweisend:
eine Anzeigeeinheit (100), die angepasst ist, um ein Bild entsprechend Datensignalen, Ansteuersignalen, einer ersten Versorgungsspannung und einer zweiten Versorgungsspannung anzuzeigen; und
einen Ansteuertreiber (300) zum Erzeugen der Ansteuersignale und zum Übertragen der erzeugten Ansteuersignale zur Anzeigeeinheit (100),
**gekennzeichnet durch** eine Treiberschaltung nach Anspruch 1.

3. Organische lichtemittierende Anzeigevorrichtung nach Anspruch 2, wobei die Anzeigeeinheit (100) eine Vielzahl von Pixeln (101) aufweist, wobei jeder aus der Vielzahl der Pixel (101) eine organische lichtemittierende Diode (OLED) zum Emittieren von Licht gemäß der ersten Versorgungsspannung (ELVDD) und den Datensignalen aufweist.

4. Organische lichtemittierende Anzeigevorrichtung nach Anspruch 3, wobei jeder aus der Vielzahl der Pixel (101) weiterhin zumindest einen Dünnfilmtransistor (M1), der eine Source-Elektrode, die mit der ersten Versorgungsspannung (ELVDD) gekoppelt ist, eine Gate-Elektrode, die angepasst ist, um die Datensignale vom Datentreiber zu erhalten, und eine Drain-Elektrode, die mit der organischen lichtemittierenden Diode (OLED) gekoppelt ist, aufweist.

5. Organische lichtemittierende Anzeigevorrichtung nach einem der Ansprüche 2 bis 4, wobei die Gammakorrektureinheit (500) konfiguriert ist, um Graustufenspannungen für 64 Graustufen zu erzeugen.

## Revendications

1. Circuit de commande comprenant :
une unité de correction de gamma (500) conçue pour générer une pluralité de tensions de niveau de gris en fonction de l'une sélectionnée d'une pluralité de courbes de gamma prédéterminées et d'une tension de référence ;
un pilote de données (200) conçu pour générer des signaux de données en sélectionnant l'une de la pluralité de tensions de niveau de gris en fonction d'un signal d'image ; et
une unité d'alimentation (400) conçue pour générer une première tension d'alimentation (ELVDD) et une deuxième tension d'alimentation (ELVSS) ;
un générateur de tension (600) conçu pour générer la tension de référence (VREF), la tension de référence (VREF) pouvant être l'une ou l'autre d'une première tension de référence (VREF1) déduite d'une tension d'alimentation d'entrée fournie à partir de l'extérieur (VCI) ou d'une deuxième tension de référence (VREF2) déduite de la première tension d'alimentation (ELVDD), le générateur de tension (600) comprenant :
un premier générateur de tension de référence (610) conçu pour générer la première tension de référence à partir de la tension d'alimentation d'entrée ;
un deuxième générateur de tension de référence (620) conçu pour générer la deuxième tension de référence à partir de la première tension d'alimentation (ELVDD) ; et
un sélecteur (630) conçu pour sélectionner l'une de la première tension de référence ou de la deuxième tension de référence et pour fournir l'une sélectionnée de la première tension de référence ou de la deuxième tension de référence à l'unité de correction de gamma (500), et
**caractérisé en ce que** :
le sélecteur (630) est configuré pour sélectionner la première tension de référence pendant une période de commande initiale pendant laquelle l'unité d'alimentation (400) n'est pas dans un état activé et pour sélectionner la deuxième tension de référence après la période de commande initiale après laquelle l'unité d'alimentation (400) est dans un état activé.

2. Dispositif d'affichage électroluminescent organique comprenant :
une unité d'affichage (100) conçue pour afficher une image correspondant à des signaux de données, des signaux de balayage, une première tension d'alimentation et une deuxième tension d'alimentation ; et
un circuit de commande de balayage (300) pour générer les signaux de balayage et pour transmettre les signaux de balayage générés à l'unité d'affichage (100),
**caractérisé par** un circuit de commande selon la revendication 1.

3. Dispositif d'affichage électroluminescent organique selon la revendication 2, dans lequel l'unité d'affichage (100) comprend une pluralité de pixels (101), chacun de la pluralité de pixels (101) comprenant une diode électroluminescente organique (OLED) pour émettre une lumière en fonction de la première tension d'alimentation (ELVDD) et des signaux de données.

4. Dispositif d'affichage électroluminescent organique selon la revendication 3, dans lequel chacun de la pluralité de pixels (101) comprend en outre au moins un transistor à couches minces (M1) ayant une électrode de source couplée à la première tension d'alimentation (ELVDD), une électrode de grille conçue pour recevoir les signaux de données du pilote de données, et une électrode de drain couplée à la diode électroluminescente organique (OLED).

5. Dispositif d'affichage électroluminescent organique selon l'une des revendications 2 à 4, dans lequel l'unité de correction de gamma (500) est configurée pour générer des tensions de niveau de gris pour 64 niveaux de gris.
